# EUROPÄISCHE PATENTSCHRIFT

(11) **EP 3 635 862 B1**
(45) Veröffentlichungstag und Bekanntmachung des Hinweises auf die Patenterteilung: **22.12.2021**
(21) Anmeldenummer: 18718812.3
(22) Anmeldetag: 19.04.2018
(51) Int. Cl.: H03H 1/00, H02P 6/10, H04B 15/00, H02K 11/00

(54) **GESTEUERTE LASTVORRICHTUNG UND HERSTELLUNGSVERFAHREN FÜR EINE GESTEUERTE LASTVORRICHTUNG**
CONTROLLED LOAD APPARATUS AND METHOD FOR PRODUCING A CONTROLLED LOAD APPARATUS
DISPOSITIF DE CHARGE COMMANDÉ ET PROCÉDÉ DE FABRICATION D'UN DISPOSITIF DE CHARGE COMMANDÉ

(30) Priorität: 09.06.2017 DE 102017209742
(43) Veröffentlichungstag der Anmeldung: 15.04.2020
(73) Patentinhaber: Robert Bosch GmbH, 70442 Stuttgart (DE)
(72) Erfinder: HUEBL, Jochen, 71701 Schwieberdingen (DE); KUBACH, Michael, 71642 Ludwigsburg (DE); KRALICEK, Peter, 71672 Marbach (DE)
(86) Internationale Anmeldenummer: PCT/EP2018/059996
(87) Internationale Veröffentlichungsnummer: WO 2018/224213

(56) Entgegenhaltungen:
- DE-A1-102012 104 454
- DE-U1- 9 418 804

## Beschreibung

Die Erfindung betrifft eine gesteuerte Lastvorrichtung. Ebenso betrifft die Erfindung ein Herstellungsverfahren für eine gesteuerte Lastvorrichtung.

### Stand der Technik

In der DE 10 2004 043 103 B4 ist ein Strom- und Datenverteilungssystem mit einem Motor als Last beschrieben. Der Motor ist an einem Steuergerät derart angebunden, dass ein Wechselstrom über Drähte an den Motor bereitstellbar ist. Außerdem schlägt die DE 10 2004 043 103 B4 einen zusätzlichen neutralen Draht zur Rückführung von Stromsignalen vor.

Die Offenlegung DE 102012104454A1 betrifft einen Anlasser umfassend einen Motor, der durch eine Motorzuleitung mit einer Stromversorgungsleitung verbunden ist und durch von einer Batterie zugeführte Leistung ein Drehmoment erzeugt. Ferner umfasst der Anlasser einen elektromagnetischen Schalter, der einen elektrischen Kontakt einschließt, der mit der Stromversorgungsleitung über eine batterieseitige Klemme und eine motorseitige Klemme verbunden ist.

Das Gebrauchsmuster DE 9418 804 U1 offenbart einen Elektroantrieb mit einem Gleichspannungs-Elektromotor, der in einem Motorgehäuse untergebracht ist und Motorwicklungen aufweist, und mit einer mit den Motorwicklungen verbundenen, einen Schaltregler aufweisenden Motorsteuerschaltung zur Steuerung des Elektromotors, die auf einer Leiterplatte angeordnet ist und eine Massefläche für den Anschluss der Leiterplatte an Massepotential aufweist.

### Offenbarung der Erfindung

Die Erfindung betrifft eine gesteuerte Lastvorrichtung mit den Merkmalen des Anspruchs 1 und ein Herstellungsverfahren für eine gesteuerte Lastvorrichtung mit den Merkmalen des Anspruchs 14.

### Vorteile der Erfindung

Die vorliegende Erfindung schafft eine Impedanzverbesserung einer mittels zumindest des mindestens einen Leiters und der ersten elektromechanischen Rückführungskomponente gebildeten elektromechanischen Anbindung der Last an die Steuerelektronik. Dies bewirkt eine deutlich verbesserte Rückführung von Störsignalen, insbesondere von hochfrequenten Störsignalen, aus der Last in die Steuerelektronik.

Durch die erfindungsgemäße Festlegung der ersten Rückführungs-Impedanzminimumfrequenz der ersten elektromechanischen Rückführungskomponente bezüglich der Last- Impedanzminimumfrequenz der über den mindestens einen Leiter mit der Steuerelektronik verbundenen Last können der mindestens eine Leiter und die erste elektromechanische Rückführungskomponente so miteinander wechselwirken, dass eine deutliche Verbesserung bei der Rückführung der hochfrequenten Störsignale erreicht wird. Die hochfrequenten Störsignale können damit effektiver in die Steuerelektronik "zurückgeholt" werden.

Beispielsweise kann die erste elektromechanische Rückführungskomponente die erste Rückführungs-Impedanz mit dem ersten Rückführungs-Impedanzminimum bei der ersten Rückführungs-Impedanzminimumfrequenz zwischen 10% der Last-Impedanzminimumfrequenz und 100% der Last-Impedanzminimumfrequenz, insbesondere zwischen 20% der Last-Impedanzminimumfrequenz und 100% der Last-Impedanzminimumfrequenz, speziell zwischen 40% der Last-Impedanzminimumfrequenz und 100% der Last-Impedanzminim umfrequenz, aufweisen. Die erste Rückführungs-Impedanzminimumfrequenz kann somit so "nahe" an der Last-Impedanzminimumfrequenz liegen, dass der mindestens eine Leiter und die parallel dazu angeordnete erste elektromechanische Rückführungskomponente die gewünschte Wechselwirkung zur optimierten Rückführung von Störsignalen sicherstellen.

Bevorzugter Weise ist die erste Rückführungs-Impedanzminimumfrequenz der ersten elektromechanischen Rückführungskomponente mittels einer Güte und/oder einer Resonanzfrequenz der ersten elektromechanischen Rückführungskomponente festgelegt. Zum Festlegen der ersten Rückführungs-Impedanzminimumfrequenz der ersten elektromechanischen Rückführungskomponente können somit kostengünstige Komponenten der ersten elektromechanischen Rückführungskomponente, wie beispielsweise mindestens ein Widerstand und/oder mindestens ein Kondensator, genutzt werden.

In einer vorteilhaften Ausführungsform umfasst die gesteuerte Lastvorrichtung eine erste Rückführfeder, einen ersten Rückführungskontakt und/oder eine erste Schraubverbindung als die erste elektromechanische Rückführungskomponente. Als die erste elektromechanische Rückführungskomponente können somit kostengünstige Bauteile eingesetzt werden.

Als vorteilhafte Weiterbildung kann die gesteuerte Lastvorrichtung zusätzlich zu der ersten elektromechanischen Rückführungskomponente noch eine zweite elektromechanische Rückführungskomponente, welche zur Führung oder Rückführung der hochfrequenten Störsignale aus der Last in die Steuerelektronik ausgebildet ist, umfassen. Auch die zweite elektromechanische Rückführungskomponente kann zur Verbesserung der Rückführung der hochfrequenten Störsignale beitragen.

In diesem Fall liegt vorteilhafterweise eine Parallelschaltung aus der über den mindestens einen Leiter mit der Steuerelektronik verbundenen Last und der zweiten elektromechanischen Rückführungskomponente vor, welche ein Parallelschaltung-Impedanzmaximum bei einer Parallelschaltung-Impedanzmaximumfrequenz aufweist. Messungen haben gezeigt, dass in diesem Fall die Rückführung von Störsignalen, insbesondere die Rückführung von hochfrequenten Störsignalen, optimiert ist.

Vorzugsweise weist die zweite elektromechanische Rückführungskomponente eine zweite Rückführungs-Impedanz mit einem zweiten Rückführungs-Impedanzminimum bei einer zweiten Rückführungs-Impedanzminimumfrequenz kleiner als der Last-Impedanzminimumfrequenz auf, wobei die zweite Rückführungs-Impedanzminimumfrequenz kleiner als 50% der Last-Impedanzminimumfrequenz ist. Die zweite Rückführungs-Impedanzminimumfrequenz der zweiten elektromechanischen Rückführungskomponente kann somit relativ frei gewählt werden.

Auch als die zweite elektromechanische Rückführungskomponente kann die gesteuerte Lastvorrichtung eine zweite Rückführfeder, einen zweiten Rückführungskontakt und/oder eine zweite Schraubverbindung umfassen. Somit kann auch die zweite elektromechanische Rückführungskomponente relativ kostengünstig und vergleichsweise einfach ausgebildet sein.

Vorteilhafterweise kann die Last ein Motor, ein Ventil, eine Lichtemittiereinrichtung und/oder ein Elektronikgerät sein. Die Last kann in und/oder an einem Fahrzeug verbaubar oder verbaut sein. Insbesondere kann die Last ein elektrischer Bremskraftverstärkermotor, ein Pumpenmotor oder ein Bremssystemventil sein. Die hier beschriebene Erfindung ist somit für eine Vielzahl von verschiedenen Lasten nutzbar. Es wird jedoch darauf hingewiesen, dass die hier aufgezählten Ausbildungsmöglichkeiten für die Last nur beispielhaft zu interpretieren sind.

Die vorausgehend beschriebenen Vorteile sind auch bei einem Ausführen eines korrespondierenden Herstellungsverfahrens für eine gesteuerte Lastvorrichtung gewährleistet. Es wird ausdrücklich darauf hingewiesen, dass das Herstellungsverfahren gemäß den oben erläuterten Ausführungsformen der gesteuerten Lastvorrichtung weiterbildbar ist.

### Kurze Beschreibung der Zeichnungen

Weitere Merkmale und Vorteile der vorliegenden Erfindung werden nachfolgend anhand der Figuren erläutert. Es zeigen:
- Fig. 1a bis 1d: schematische Darstellungen und Koordinatensysteme zum Erläutern einer Ausführungsform der gesteuerten Lastvorrichtung; und
- Fig. 2: ein Flussdiagramm zum Erläutern einer Ausführungsform des Herstellungsverfahrens für eine gesteuerte Lastvorrichtung.

### Ausführungsformen der Erfindung

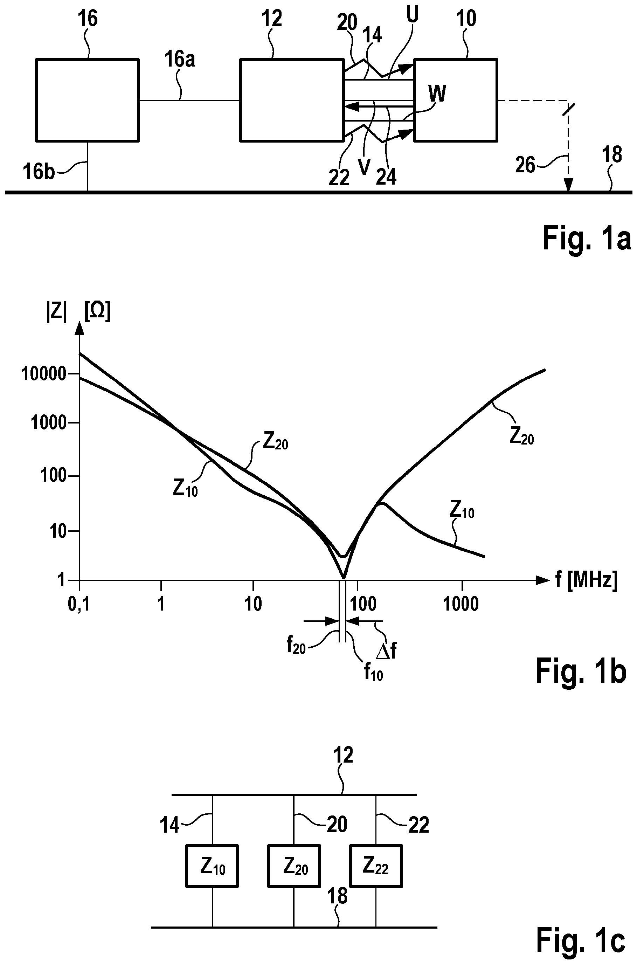

Fig. 1a bis 1d zeigen schematische Darstellungen und Koordinatensysteme zum Erläutern einer Ausführungsform der gesteuerten Lastvorrichtung.

Die mittels der Fig. 1a bis 1d schematisch wiedergegebene gesteuerte Lastvorrichtung umfasst eine Last 10 und eine Steuerelektronik 12, welche über mindestens einen Leiter 14 so mit der Last 10 verbunden ist, dass die Last 10 über mindestens ein über den mindestens einen Leiter 14 weitergeleitetes elektrisches Signal schaltbar/geschaltet und/oder bestrombar/bestromt ist. Die Steuerelektronik 12 kann auch als ein Steuergerät und/oder eine Ansteuerleiterplatte bezeichnet werden. Lediglich beispielhaft ist in der Ausführungsform der Fig. 1a bis 1d die Last 10 als Motor 10, z.B. als bürstenloser Gleichstrommotor 10 (BLDC, Brushless Direct Current Motor), insbesondere als bürstenloser Drei-Phasen-Motor 10, ausgebildet. Speziell kann der Motor 10 für eine getaktete Motoransteuerung ausgelegt sein. Beispielhaft ist der Motor 10 über drei Phasenleitungen U, V und W (als den mindestens einen Leiter 14) mit der Steuerelektronik 12 verbunden. Eine Ausbildbarkeit der gesteuerten Lastvorrichtung ist jedoch weder auf einen bestimmten Lasttyp oder eine spezielle Motoransteuerung noch auf eine bestimmte Ausbildung des mindestens einen Leiters 14 beschränkt. Außerdem kann die Last 10 auch ein Ventil, eine Lichtemittiereinrichtung (wie z.B. eine Vorrichtung mit mindestens einer lichtemittierenden Diode) und/oder ein Elektronikgerät, wie insbesondere ein Haushaltsgerät, ein Materialverarbeitungsgerät (z.B. eine elektrische Säge) und/oder ein Hochleistungsgerät, sein. Ebenso wird darauf hingewiesen, dass die hier aufgezählten Beispiele zur Ausbildung der Last 10 nur beispielhaft zu interpretieren sind.

Beispielhaft ist die Steuerelektronik 12 in dem Beispiel der Fig. 1a bis 1d noch an ein Bordnetz 16 angebunden. (Von den Leitungen 16a und 16b des Bordnetzes 16 sind in Fig. 1a lediglich eine erste Leitung 16a und eine zweite Leitung 16b beispielhaft skizziert.) Außerdem sind die Komponenten 10, 12 und 16 fahrzeugeigene Komponenten 10, 12 und 16, wobei von den weiteren Fahrzeugkomponenten beispielhaft nur ein Chassis 18 in Fig. 1a dargestellt ist. Wie unten genauer erläutert wird, ist die im Weiteren beschriebene gesteuerte Lastvorrichtung vor allem an/in einem Fahrzeug/Kraftfahrzeug vorteilhaft einsetzbar. Somit ist es vorteilhaft, wenn die Last 10 in/an einem Fahrzeug/Kraftfahrzeug verbaubar/verbaut ist. Beispielsweise kann die Last ein elektrischer Bremskraftverstärkermotor, ein Pumpenmotor oder ein Bremssystemventil sein. Es wird jedoch darauf hingewiesen, dass eine Verwendbarkeit der gesteuerten Lastvorrichtung nicht auf Fahrzeuge/Kraftfahrzeuge limitiert ist.

Bedingt durch eine Ansteuerung und eine Konstruktion der Last 10 werden während deren Betrieb als Störsignale bezeichenbare (elektromagnetische) Emissionen erzeugt. Beispielsweise können Motoransteuersignale und/oder ein Motorstrom der als Motor 10 ausgebildeten Last 10 parasitär in deren Gehäuse/Motorgehäuse auskoppeln. Erwünscht ist eine verlässliche Führung/Rückführung der Störsignale, insbesondere hochfrequenter Störsignale, aus der Last 10 (direkt) in die Steuerelektronik 12.

In das Koordinatensystem der Fig. 1b ist eine (frequenzabhängige) Last-Impedanz Z₁₀ der über den mindestens einen Leiter 14 mit der Steuerelektronik 12 verbundenen Last 10 eingezeichnet, wobei eine Abszisse des Koordinatensystems Frequenzen f (in MHz/Megahertz) und eine Ordinate des Koordinatensystems einen Impedanzbetrag |Z| (in Ω/Ohm) wiedergeben. Die physikalische Größe "Impedanz" beschreibt eine Eigenschaft einer Leitung oder eines Mediums bei der elektromechanischen Wellenausbreitung. Sofern die Last 10 als Motor 10 ausgebildet ist, kann die Last-Impedanz Z₁₀ der über den mindestens einen Leiter 14 mit der Steuerelektronik 12 verbundenen Last 10 auch als Motorimpedanz Z₁₀ bezeichnet werden. Für die Last-Impedanz Z₁₀ der über den mindestens einen Leiter 14 mit der Steuerelektronik 12 verbundenen Last 10 sind beispielsweise eine Induktivität des mindestens einen Leiters 14 und/oder eine Kapazität einer Motorwicklung der Last 10 signifikante Größen.

Wie in Fig. 1b erkennbar ist, weist die Last-Impedanz Z₁₀ der über den mindestens einen Leiter 14 mit der Steuerelektronik 12 verbundenen Last 10 ein Last-Impedanzminimum bei einer Last-Impedanzminimumfrequenz f₁₀ auf. Die Last-Impedanzminimumfrequenz f₁₀ ist konstruktionsbedingt. Häufig liegt die Last-Impedanzminimumfrequenz f₁₀ zwischen 5 MHz (Megahertz) und 300 MHz (Megahertz), oft zwischen 70 MHz (Megahertz) und 200 MHz (Megahertz), manchmal zwischen 80 MHz (Megahertz) und 150 MHz (Megahertz), beispielsweise zwischen 80 MHz (Megahertz) und 100 MHz (Megahertz). Damit liegt die Last-Impedanzminimumfrequenz f₁₀ in einem Frequenzbereich, in welchem die Führung/Rückführung der hochfrequenten Störsignale aus der Last 10 in die Steuerelektronik 12 vor allem gewünscht ist.

An der gesteuerten Lastvorrichtung ist deshalb auch eine erste elektromechanische Rückführungskomponente 20 ausgebildet, welche zur Führung oder Rückführung hochfrequenter Störsignale aus der Last 10 in die Steuerelektronik 12 ausgelegt ist. Die erste elektromechanische Rückführungskomponente 20 verläuft vorzugsweise zwischen der Last 10 und der Steuerelektronik 12 so, dass die Last 10 auch über die erste elektromechanische Rückführungskomponente 20 mit der Steuerelektronik 12 verbunden ist. Man kann dies auch damit umschreiben, dass die erste elektromechanische Rückführungskomponente 20 parallel zu dem mindestens einen Leiter 14 angeordnet/ausgebildet ist. (Unter der ersten elektromechanischen Rückführungskomponente 20 ist jedoch keine Leitungskomponente zum Weiterleiten eines zum Steuern, Schalten und/oder Bestromen der Last 10 eingesetzten elektrischen Signals von der Steuerelektronik 12 zu der Last 10 zu verstehen.) Die erste elektromechanische Rückführungskomponente 20 ermöglicht eine zusätzliche Anbindung der Last 10 an die Steuerelektronik 16, welche zur Steigerung der Führung/Rückführung von Störsignalen, insbesondere von hochfrequenten Störsignalen, aus der Last 10 in die Steuerelektronik 12 beiträgt.

In das Koordinatensystem der Fig. 1b ist auch eine (frequenzabhängige) erste Rückführungs-Impedanz Z₂₀ der ersten elektromechanischen Rückführungskomponente 20 eingezeichnet. Erkennbar ist, dass die erste Rückführungs-Impedanz Z₂₀ der ersten elektromechanischen Rückführungskomponente 20 ein erstes Rückführungs-Impedanzminimum bei einer ersten Rückführungs-Impedanzminimumfrequenz f₂₀ zwischen 1% der Last-Impedanzminimumfrequenz f₁₀ und 100% der Last-Impedanzminimumfrequenz f₁₀ aufweist. (Eine Frequenzdifferenz Δf zwischen der Last-Impedanzminimumfrequenz f₁₀ und der ersten Rückführungs-Impedanzminimumfrequenz f₂₀ ist ebenfalls eingezeichnet.) Während somit die Last 10 mit dem mindestens einen Leiter 14 einen ersten "Schwingkreis"/ein erstes "Resonanzsystem" mit der Last-Impedanzminimumfrequenz f₁₀ darstellt, kann die erste elektromechanische Rückführungskomponente 20 als ein zweiter "Schwingkreis"/ein zweites "Resonanzsystem" mit der ersten Rückführungs-Impedanzminimumfrequenz f₂₀ bezeichnet werden, welches aufgrund der vergleichsweise geringen Frequenzdifferenz Δf zwischen der Last-Impedanzminimumfrequenz f₁₀ und der ersten Rückführungs-Impedanzminimumfrequenz f₂₀ mit dem ersten "Schwingkreis"/ersten "Resonanzsystem" gekoppelt ist. Die Last 10 mit dem mindestens einen Leiter 14 und die erste elektromechanische Rückführungskomponente 20 können deshalb als zwei miteinander gekoppelte "Schwingkreise"/"Resonanzsysteme" (bzw. als ein "Gesamt-Schwingkreise"/"Gesamt-Resonanzsystem") umschrieben werden. Somit können hochfrequente Störsignale besser in die Steuerelektronik 12 rückgeführt werden. Die erste elektromechanische Rückführungskomponente 20 ermöglicht deshalb eine Kompensationsanbindung, welche gezielt konstruktionsbedingte Nachteile der Anbindung der Last 10 an die Steuerelektronik 12 über den mindestens einen Leiter 14 behebt.

Aufgrund der verbesserten Rückführung der hochfrequenten Störsignale aus der Last 10 in die Steuerelektronik 12 ist eine Einleitung der hochfrequenten Störsignale in das Chassis 18 oder eine weitere Fahrzeugkomponenten (im Wesentlichen) unterbunden. Deshalb muss nicht/kaum befürchtet werden, dass die hochfrequenten Störsignale eine große Schleife durch das Chassis 18 und das Bordnetz 16 zur Steuerelektronik 12 zurücklaufen.

Ein erster Rückführungs-Impedanzminimumwert (von etwa 3Ω (Ohm)) des ersten Rückführungs-Impedanzminimums der ersten Rückführungs-Impedanz Z₂₀ kann deutlich größer als ein Last-Impedanzminimumwert (von etwa 1Ω (Ohm)) des Last-Impedanzminimums der Last-Impedanz Z₁₀ sein. Vorzugsweise liegt die erste Rückführungs-Impedanzminimumfrequenz f₂₀ zwischen 10% der Last-Impedanzminimumfrequenz f₁₀ und 100% der Last-Impedanzminimumfrequenz f₁₀, insbesondere zwischen 20% der Last-Impedanzminimumfrequenz f₁₀ und 100% der Last-Impedanzminimumfrequenz f₁₀, speziell zwischen 40% der Last-Impedanzminimumfrequenz f₁₀ und 100% der Last-Impedanzminimumfrequenz f₁₀. Die erste Rückführungs-Impedanzminimumfrequenz f₂₀ der ersten elektromechanischen Rückführungskomponente 20 kann auf einfache Weise und verlässlich mittels einer Güte und/oder einer Resonanzfrequenz der ersten elektromechanischen Rückführungskomponente 20 entsprechend festgelegt sein/werden. Dazu kann mindestens eine physikalische Größe von mindestens einem Widerstand und/oder mindestens einem Kondensator der ersten elektromechanischen Rückführungskomponente 20 entsprechend festgelegt sein/werden.

Die gesteuerte Lastvorrichtung kann eine erste Rückführfeder, einen ersten Rückführungskontakt und/oder eine erste Schraubverbindung als die erste elektromechanische Rückführungskomponente 20 umfassen. Die erste elektromechanische Rückführungskomponente 20 ist damit relativ kostengünstig mit ihren vorteilhaften Eigenschaften realisierbar.

Außerdem weist die gesteuerte Lastvorrichtung der Fig. 1a bis 1d (zusätzlich zu der ersten elektromechanischen Rückführungskomponente 20) noch eine zweite elektromechanische Rückführungskomponente 22, welche zur Führung oder Rückführung der hochfrequenten Störsignal aus der Last 10 in die Steuerelektronik 12 ausgebildet ist, auf. Auch die zweite elektromechanische Rückführungskomponente 22 verläuft vorzugsweise zwischen der Last 10 und der Steuerelektronik 12 so, dass die Last 10 über die zweite elektromechanische Rückführungskomponente 22 mit der Steuerelektronik 12 verbunden ist. In diesem Fall ist die zweite elektromechanische Rückführungskomponente 22 parallel zu dem mindestens einen Leiter 14 und/oder parallel zu der ersten elektromechanischen Rückführungskomponente 20 ausgebildet. (Unter der zweiten elektromechanischen Rückführungskomponente 22 ist aber keine Leitungskomponente zum Weiterleiten eines zum Steuern, Schalten und/oder Bestromen der Last 10 eingesetzten elektrischen Signals von der Steuerelektronik 12 zu der Last 10 zu verstehen.) Die zweite elektromechanische Rückführungskomponente 22 kann z.B. eine zweite Rückführfeder, ein zweiter Rückführungskontakt und/oder eine zweite Schraubverbindung sein. Auch die zweite elektromechanische Rückführungskomponente 22 kann so mit einer (nicht dargestellten) zweiten Rückführungs-Impedanz Z₂₂ (insbesondere mit einem zweiten Rückführungs-Impedanzminimum bei einer zweiten Rückführungs-Impedanzminimumfrequenz) ausgebildet sein, dass die Führung/Rückführung der hochfrequenten Störsignale aus der Last 10 in die Steuerelektronik 12 verbessert/gesteigert ist. Beispielsweise kann dazu die zweite Rückführungs-Impedanzminimumfrequenz kleiner als 50% der Last-Impedanzminimumfrequenz f₁₀ z.B. kleiner als 30% der Last-Impedanzminimumfrequenz f₁₀, insbesondere kleiner als 10% der Last-Impedanzminimumfrequenz f₁₀,speziell kleiner als 1% der Last-Impedanzminimumfrequenz f₁₀, (festgelegt) sein. (In dem wiedergegebenen Beispiel liegt die zweite Rückführungs-Impedanzminimumfrequenz z.B. im kHz-Bereich). Es wird darauf hingewiesen, dass unter dem zweiten Rückführungs-Impedanzminimum vorzugsweise kein designtes Impedanzminimum zu verstehen ist.

Es wird auch darauf hingewiesen, dass die zweite elektromechanische Rückführungskomponente 22 unabhängig von einer Ausbildung der ersten elektromechanischen Rückführungskomponente 20 realisierbar ist. Eine bestimmte geometrische Ausdehnung/Ausbildung der zweiten elektromechanischen Rückführungskomponente 22 ist nicht erforderlich zur Verbesserung der Führung/Rückführung der hochfrequenten Störsignale von der Last 10 zu der Steuerelektronik 12 mittels der ersten elektromechanischen Rückführungskomponente 20. Auch eine Induktivität der zweiten elektromechanischen Rückführungskomponente 22 spielt bei der mittels der ersten elektromechanischen Rückführungskomponente 20 bewirkten Entstörwirkung kaum eine Rolle.

Wie in Fig. 1c schematisch wiedergegeben ist, bilden der mindestens eine Leiter 14 mit der Last 10, die erste elektromechanische Rückführungskomponente 20 und die zweite elektromechanische Rückführungskomponente 22 jeweils einen "Pfad" für Störsignale/hochfrequente Störsignale zwischen der Steuerelektronik 12 und dem Chassis 18, d.h. insgesamt drei "Pfade". Die drei "Pfade" sind parallel zueinander geschaltet, wie mittels der Gesamt-Parallelschaltung aus den drei Pfaden der Fig. 1c schematisch wiedergegeben ist.

Die über den mindestens einen Leiter 14 mit der Steuerelektronik 12 verbundene Last 10 und die zweite elektromechanische Rückführungskomponente 22 bilden eine "Parallelschaltung" mit einem Parallelschaltung-Impedanzmaximum bei einer Parallelschaltung-Impedanzmaximumfrequenz. Aufgrund der Überlagerung ihrer Frequenzgänge koppeln in diesem Fall die "Parallelschaltung" und die erste elektromechanische Rückführungskomponente 20 miteinander und bilden die bezüglich der Führung/Rückführung von Störsignalen optimierte Gesamt-Parallelschaltung (aus der über den mindestens einen Leiter 14 mit der Steuerelektronik 12 verbundenen Last 10 und den elektromechanischen Rückführungskomponenten 20 und 22) mit einer Gesamt-Impedanz Zₜₒₜₐₗ mit einem Gesamt-Impedanzminimum bei einer Gesamt-Impedanzminimumfrequenz fₜₒₜₐₗ ungleich der Last-Impedanzminimumfrequenz f₁₀.

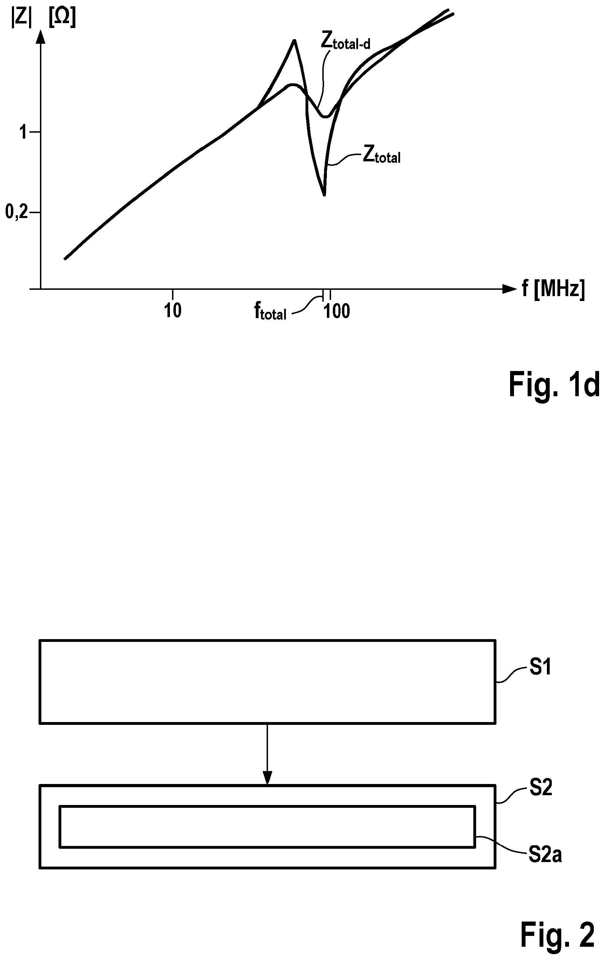

In das Koordinatensystem der Fig. 1d sind die (ungedämpfte) Gesamt-Impedanz Zₜₒₜₐₗ und eine gedämpfte Gesamt-Impedanz Z_{total-d} eingezeichnet, wobei eine Abszisse des Koordinatensystems Frequenzen f (in MHz/Megahertz) und eine Ordinate des Koordinatensystems einen Impedanzbetrag |Z| (in Ω/Ohm) wiedergeben. Erkennbar ist, dass die "Zusammenschaltung" die Gesamt-Impedanz Zₜₒₜₐₗ mit einem "neuen" Maximum und einem "neuen" Minimum ergibt. Die "Zusammenschaltung" bewirkt somit einen verbesserten Rückführungspfad zur Rückführung von Emissionen von Störungen/hochfrequenten Störungen im Frequenzbereich der Last-Impedanzminimumfrequenz f₁₀, wie mittels eines (dicken) Pfeils 24 in Fig. 1a schematisch dargestellt ist. Durch die gedämpfte Gesamt-Impedanz Z_{total-d} kann außerdem eine weniger starke Ausbildung des "neuen" Maximums und des "neuen" Minimums bewirkt werden.

Es wird hier auch darauf hingewiesen, dass die gesteuerte Last der Fig. 1a und 1b (aufgrund ihrer Ausbildung zumindest mit der ersten elektromechanischen Rückführungskomponente 20) eine derart verbesserte Rückführung aufweist, dass (im Wesentlichen) keine Störsignale, insbesondere (nahezu) keine hochfrequenten Störsignale, an das Chassis 18 (bzw. eine entsprechende Masseanbindung) abfließen. Dies ist mittels eines durchbrochenen und durchgestrichenen Pfeils 26 in Fig. 1a bildlich wiedergegeben. Dieser Vorteil ist selbst bei einem (in Fig. 1a nicht skizzierten) Befestigen der Last 10 an dem Chassis 18, wie z.B. einem Festschrauben der Last 10 an dem Chassis 18, gewährleistet. Die Ausbildung zumindest mit der ersten elektromechanischen Rückführungskomponente 20 eignet sich deshalb besonders gut für einen (in der Regel an dem Chassis 18 festgeschraubten) elektromechanischen Bremskraftverstärker als Last 10.

Fig. 2 zeigt ein Flussdiagramm zum Erläutern einer Ausführungsform des Herstellungsverfahrens für eine gesteuerte Lastvorrichtung.

Das im Weiteren beschriebene Herstellungsverfahren kann beispielsweise zum Bilden der oben erläuterten gesteuerten Lastvorrichtung genutzt werden. Eine Ausführbarkeit des Herstellungsverfahrens ist jedoch nicht auf diese Ausführungsform der gesteuerten Lastvorrichtung beschränkt.

In einem Verfahrensschritt S1 wird eine (spätere) Last der gesteuerten Lastvorrichtung über mindestens einen Leiter so mit einer (späteren) Steuerelektronik der gesteuerten Lastvorrichtung, dass die Last (während eines Betriebs der gesteuerten Lastvorrichtung) mittels mindestens eines über den mindestens einen Leiter weitergeleiteten elektrischen Signals schaltbar/geschaltet und/oder bestrombar/bestromt ist/wird. Während des Betriebs der gesteuerten Lastvorrichtung weist die über den mindestens einen Leiter mit der Steuerelektronik verbundene Last damit eine Last-Impedanz mit einem Last-Impedanzminimum bei einer Last-Impedanzminimumfrequenz auf.

In einem weiteren Verfahrensschritt S2 wird zumindest eine erste elektromechanische Rückführungskomponente zur Führung oder Rückführung hochfrequenter Störsignal aus der Last in die Steuerelektronik ausgebildet. In einem Teilschritt S2a des Verfahrensschritts S2 wird eine erste Rückführungs-Impedanz der ersten elektromechanischen Rückführungskomponente mit einem ersten Rückführungs-Impedanzminimum bei einer ersten Rückführungs-Impedanzminimumfrequenz zwischen 1% der Last-Impedanzminimumfrequenz (f₁₀) und 100% der Last-Impedanzminimumfrequenz (f₁₀)festgelegt,. Damit trägt auch das hier beschriebene Herstellungsverfahren zur besseren Emissions-Abführung bei einer damit hergestellten gesteuerten Lastvorrichtung bei. Durch ein Ausführen des Teilschritts S2a kann die Führung/Rückführung der hochfrequenten Störsignale aus der Last in die Steuerelektronik so verbessert werden, dass eine Auskoppelung der hochfrequenten Störungen in eine andere die Last umgebende Komponente (im Wesentlichen) unterbunden ist. Bei einem Ausführen des Teilschritts S2a entfällt auch eine Notwendigkeit einer konstruktionsbedingten Anpassung oder Überwindung des Last-Impedanzminimums der Last-Impedanz der Last.

Beispielsweise kann im Teilschritt S2a die erste Rückführungs-Impedanzminimumfrequenz der ersten elektromechanischen Rückführungskomponente mittels einer Güte und/oder einer Resonanzfrequenz der ersten elektromechanischen Rückführungskomponente festgelegt werden. Zum Festlegen des Impedanzminimums der ersten elektromechanischen Rückführungskomponente können beispielsweise mindestens ein Widerstand und/oder mindestens ein Kondensator der ersten elektromechanischen Rückführungskomponente genutzt werden.

Optionaler Weise kann auch die oben erläuterte zweite elektromechanische Rückführungskomponente in dem Verfahrensschritt S2 (bzw. in einem nichtdargestellten weiteren Verfahrensschritt) ebenfalls ausgebildet werden. Die Verfahrensschritte S1 und S2 können auch in beliebiger Reihenfolge, gleichzeitig oder zumindest zeitlich überschneidend ausgeführt werden.

## Patentansprüche

1. Gesteuerte Lastvorrichtung mit:
einer Last (10);
einer Steuerelektronik (12), welche über mindestens einen Leiter (14) so mit der Last (10) verbunden ist, dass die Last (10) über mindestens ein über den mindestens einen Leiter (14) weitergeleitetes elektrisches Signal schaltbar und/oder bestrombar ist,
wobei die über den mindestens einen Leiter (14) mit der Steuerelektronik (12) verbundene Last (10) eine Last-Impedanz (Z₁₀) mit einem Last-Impedanzminimum bei einer Last-Impedanzminimumfrequenz (f₁₀) aufweist; und
zumindest einer ersten elektromechanischen Rückführungskomponente (20), welche zur Führung oder Rückführung hochfrequenter Störsignale aus der Last (10) in die Steuerelektronik (12) ausgebildet ist;
**dadurch gekennzeichnet, dass**
die erste elektromechanische Rückführungskomponente (20) eine erste Rückführungs-Impedanz (Z₂₀) mit einem ersten Rückführungs-Impedanzminimum bei einer ersten Rückführungs-Impedanzminimumfrequenz (f₂₀) zwischen 1% der Last-Impedanzminimumfrequenz (f₁₀) und 100% der Last-Impedanzminimumfrequenz (f₁₀) aufweist.

2. Gesteuerte Lastvorrichtung nach Anspruch 1, wobei die erste elektromechanische Rückführungskomponente (20) die erste Rückführungs-Impedanz (Z₂₀) mit dem ersten Rückführungs-Impedanzminimum bei der ersten Rückführungs-Impedanzminimumfrequenz (f₂₀) zwischen 10% der Last-Impedanzminimumfrequenz (f₁₀) und 100% der Last-Impedanzminimumfrequenz (f₁₀) aufweist.

3. Gesteuerte Lastvorrichtung nach Anspruch 2, wobei die erste elektromechanische Rückführungskomponente (20) die erste Rückführungs-Impedanz (Z₂₀) mit dem ersten Rückführungs-Impedanzminimum bei der ersten Rückführungs-Impedanzminimumfrequenz (f₂₀) zwischen 20% der Last-Impedanzminimumfrequenz (f₁₀) und 100% der Last-Impedanzminimumfrequenz (f₁₀) aufweist.

4. Gesteuerte Lastvorrichtung nach Anspruch 3, wobei die erste elektromechanische Rückführungskomponente (20) die erste Rückführungs-Impedanz (Z₂₀) mit dem ersten Rückführungs-Impedanzminimum bei der ersten Rückführungs-Impedanzminimumfrequenz (f₂₀) zwischen 40% der Last-Impedanzminimumfrequenz (f₁₀) und 100% der Last-Impedanzminimumfrequenz (f₁₀) aufweist.

5. Gesteuerte Lastvorrichtung nach einem der vorhergehenden Ansprüche, wobei die erste Rückführungs-Impedanzminimumfrequenz (f₂₀) der ersten elektromechanischen Rückführungskomponente (20) mittels einer Güte und/oder einer Resonanzfrequenz der ersten elektromechanischen Rückführungskomponente (20) festgelegt ist.

6. Gesteuerte Lastvorrichtung nach einem der vorhergehenden Ansprüche, wobei die gesteuerte Lastvorrichtung eine erste Rückführfeder, einen ersten Rückführungskontakt und/oder eine erste Schraubverbindung als die erste elektromechanische Rückführungskomponente (20) umfasst.

7. Gesteuerte Lastvorrichtung nach einem der vorhergehenden Ansprüche, wobei die gesteuerte Lastvorrichtung zusätzlich zu der ersten elektromechanischen Rückführungskomponente (20) noch eine zweite elektromechanische Rückführungskomponente (22), welche zur Führung oder Rückführung der hochfrequenten Störsignale aus der Last (10) in die Steuerelektronik (12) ausgebildet ist, umfasst.

8. Gesteuerte Lastvorrichtung nach Anspruch 7, wobei eine Parallelschaltung aus der über den mindestens einen Leiter (14) mit der Steuerelektronik (12) verbundenen Last (10) und der zweiten elektromechanischen Rückführungskomponente (22) ein Parallelschaltung-Impedanzmaximum bei einer Parallelschaltung-Impedanzmaximumfrequenz aufweist.

9. Gesteuerte Lastvorrichtung nach Anspruch 7 oder 8, wobei die zweite elektromechanische Rückführungskomponente (22) eine zweite Rückführungs-Impedanz (Z₂₂) mit einem zweiten Rückführungs-Impedanzminimum bei einer zweiten Rückführungs-Impedanzminimumfrequenz kleiner als der Last-Impedanzminimumfrequenz (f₁₀) aufweist, und wobei die zweite Rückführungs-Impedanzminimumfrequenz kleiner als 50% der Last-Impedanzminimumfrequenz (f₁₀) ist.

10. Gesteuerte Lastvorrichtung nach einem der Ansprüche 7 bis 9, wobei die gesteuerte Lastvorrichtung eine zweite Rückführfeder, einen zweiten Rückführungskontakt und/oder eine zweite Schraubverbindung als die zweite elektromechanische Rückführungskomponente (22) umfasst.

11. Gesteuerte Lastvorrichtung nach einem der vorhergehenden Ansprüche, wobei die Last (10) ein Motor (10), ein Ventil, eine Lichtemittiereinrichtung und/oder ein Elektronikgerät ist.

12. Gesteuerte Lastvorrichtung nach einem der vorhergehenden Ansprüche, wobei die Last (10) in und/oder an einem Fahrzeug verbaubar oder verbaut ist.

13. Gesteuerte Lastvorrichtung nach Anspruch 12, wobei die Last (10) ein elektrischer Bremskraftverstärkermotor, ein Pumpenmotor oder ein Bremssystemventil ist.

14. Herstellungsverfahren für eine gesteuerte Lastvorrichtung mit den Schritten:
Verbinden einer Last (10) der gesteuerten Lastvorrichtung über mindestens einen Leiter (14) so mit einer Steuerelektronik (12) der gesteuerten Lastvorrichtung (S1), dass die Last (10) mittels mindestens eines über den mindestens einen Leiter (14) weitergeleiteten elektrischen Signals schaltbar und/oder bestrombar ist, wobei die über den mindestens einen Leiter (14) mit der Steuerelektronik (12) verbundene Last (10) eine Last-Impedanz (Z₁₀) mit einem Last-Impedanzminimum bei einer Last-Impedanzminimumfrequenz (f₁₀) aufweist;
und
Ausbilden zumindest einer ersten elektromechanischen Rückführungskomponente (20) zur Führung oder Rückführung hochfrequenter Störsignale aus der Last (10) in die Steuerelektronik (12) (S2);
**gekennzeichnet durch** den Schritt:
Festlegen einer ersten Rückführungs-Impedanz (Z₂₀) der ersten elektromechanischen Rückführungskomponente (20) mit einem ersten Rückführungs-Impedanzminimum bei einer ersten Rückführungs-Impedanzminimumfrequenz (f₂₀) zwischen 1% der Last-Impedanzminimumfrequenz (f₁₀) und 100% der Last-Impedanzminimumfrequenz (f₁₀) .

15. Herstellungsverfahren nach Anspruch 14, wobei die erste Rückführungs-Impedanzminimumfrequenz (f₂₀) der ersten elektromechanischen Rückführungskomponente (20) mittels einer Güte und/oder einer Resonanzfrequenz der ersten elektromechanischen Rückführungskomponente (20) festgelegt wird.

## Claims

1. Controlled load apparatus having:
a load (10);
a control electronics system (12), which is connected to the load (10) by means of at least one conductor (14) in such a way that the load (10) can be switched and/or can be energized by means of at least one electrical signal transmitted by means of the at least one conductor (14);
wherein the load (10) connected to the control electronics system (12) by means of the at least one conductor (40) has a load impedance (Z₁₀) having a load impedance minimum at a load impedance minimum frequency (f₁₀); and
at least one first electromechanical feedback component (20), which is designed to feed or feed back high-frequency interference signals from the load (10) into the control electronics system (12);
**characterized in that**
the first electromechanical feedback component (20) has a first feedback impedance (Z₂₀) having a first feedback impedance minimum at a first feedback impedance minimum frequency (f₂₀) between 1% of the load impedance minimum frequency (f₁₀) and 100% of the load impedance minimum frequency (f₁₀).

2. Controlled load apparatus according to Claim 1, wherein the first electromechanical feedback component (20) has the first feedback impedance (Z₂₀) having the first feedback impedance minimum at the first feedback impedance minimum frequency (f₂₀) between 10% of the load impedance minimum frequency (f₁₀) and 100% of the load impedance minimum frequency (f₁₀).

3. Controlled load apparatus according to Claim 2, wherein the first electromechanical feedback component (20) has the first feedback impedance (Z₂₀) having the first feedback impedance minimum at the first feedback impedance minimum frequency (f₂₀) between 20% of the load impedance minimum frequency (f₁₀) and 100% of the load impedance minimum frequency (f₁₀).

4. Controlled load apparatus according to Claim 3, wherein the first electromechanical feedback component (20) has the first feedback impedance (Z₂₀) having the first feedback impedance minimum at the first feedback impedance minimum frequency (f₂₀) between 40% of the load impedance minimum frequency (f₁₀) and 100% of the load impedance minimum frequency (f₁₀).

5. Controlled load apparatus according to one of the preceding claims, wherein the first feedback impedance minimum frequency (f₂₀) of the first electromechanical feedback component (20) is stipulated by means of a quality and/or a resonant frequency of the first electromechanical feedback component (20).

6. Controlled load apparatus according to one of the preceding claims, wherein the controlled load apparatus comprises a first feedback spring, a first feedback contact and/or a first screw connection as the first electromechanical feedback component (20).

7. Controlled load apparatus according to one of the preceding claims, wherein, in addition to the first electromechanical feedback component (20), the controlled load apparatus also comprises a second electromechanical feedback component (22), which is designed to feed or feed back the high-frequency interference signals from the load (10) into the control electronics system (12).

8. Controlled load apparatus according to Claim 7, wherein a parallel circuit composed of the load (10) connected to the control electronics system (12) by means of the at least one conductor (14) and of the second electromechanical feedback component (22) has a parallel circuit impedance maximum at a parallel circuit impedance maximum frequency.

9. Controlled load apparatus according to Claim 7 or 8, wherein the second electromechanical feedback component (22) has a second feedback impedance (Z₂₂) having a second feedback impedance minimum at a second feedback impedance minimum frequency lower than the load impedance minimum frequency (f₁₀), and wherein the second feedback impedance minimum frequency is lower than 50% of the load impedance minimum frequency (f₁₀).

10. Controlled load apparatus according to one of Claims 7 to 9, wherein the controlled load apparatus comprises a second feedback spring, a second feedback contact and/or a second screw connection as the second electromechanical feedback component (22).

11. Controlled load apparatus according to one of the preceding claims, wherein the load (10) is a motor (10), a valve, a light-emitting device and/or an electronics unit.

12. Controlled load apparatus according to one of the preceding claims, wherein the load (10) can be installed or is installed in and/or on a vehicle.

13. Controlled load apparatus according to Claim 12, wherein the load (10) is an electrical brake force booster motor, a pump motor or a brake system valve.

14. Production method for a controlled load apparatus having the steps of:
connecting a load (10) of the controlled load apparatus by means of at least one conductor (14) to a control electronics system (12) of the controlled load apparatus (S1) in such a way that the load (10) can be switched and/or can be energized by means of at least one electrical signal transmitted by means of the at least one conductor (14), wherein the load (10) connected to the control electronics system (12) by means of the at least one conductor (14) has a load impedance (Z₁₀) having a load impedance minimum at a load impedance minimum frequency (f₁₀); and
designing at least one first electromechanical feedback component (20) to feed or feed back high-frequency interference signals from the load (10) into the control electronics system (12) (S2);
**characterized by** the step of:
stipulating a first feedback impedance (Z₂₀) of the first electromechanical feedback component (20) having a first feedback impedance minimum at a first feedback impedance minimum frequency (f₂₀) between 1% of the load impedance minimum frequency (f₁₀) and 100% of the load impedance minimum frequency (f₁₀).

15. Production method according to Claim 14, wherein the first feedback impedance minimum frequency (f₂₀) of the first electromechanical feedback component (20) is stipulated by means of a quality and/or a resonant frequency of the first electromechanical feedback component (20).

## Revendications

1. Dispositif de charge commandé, comprenant :
une charge (10) ;
une électronique de commande (12) qui est reliée à la charge (10) par au moins un conducteur (14) de telle sorte que la charge (10) peut être commutée et/ou alimentée par au moins un signal électrique transmis par ledit au moins un conducteur (14),
la charge (10), reliée à l'électronique de commande (12) par ledit au moins un conducteur (14), présentant une impédance de charge (Z₁₀) avec un minimum d'impédance de charge à une fréquence de minimum d'impédance de charge (f₁₀) ; et
au moins un premier élément de rétroaction électromécanique (20) qui est réalisé pour conduire ou ramener à l'électronique de commande (12) des signaux parasites haute fréquence provenant de la charge (10) ;
**caractérisé en ce que** le premier élément de rétroaction électromécanique (20) présente une première impédance de rétroaction (Z₂₀) ayant un premier minimum d'impédance de rétroaction à une première fréquence de minimum d'impédance de rétroaction (f₂₀) entre 1 % de la fréquence de minimum d'impédance de charge (f₁₀) et 100 % de la fréquence de minimum d'impédance de charge (fio) .

2. Dispositif de charge commandé selon la revendication 1, dans lequel le premier élément de rétroaction électromécanique (20) présente la première impédance de rétroaction (Z₂₀) avec le premier minimum d'impédance de rétroaction à la première fréquence de minimum d'impédance de rétroaction (f₂₀) entre 10 % de la fréquence de minimum d'impédance de charge (f₁₀) et 100 % de la fréquence de minimum d'impédance de charge (f₁₀) .

3. Dispositif de charge commandé selon la revendication 2, dans lequel le premier élément de rétroaction électromécanique (20) présente la première impédance de rétroaction (Z₂₀) avec le premier minimum d'impédance de rétroaction à la première fréquence de minimum d'impédance de rétroaction (f₂₀) entre 20 % de la fréquence de minimum d'impédance de charge (f₁₀) et 100 % de la fréquence de minimum d'impédance de charge (f₁₀) .

4. Dispositif de charge commandé selon la revendication 3, dans lequel le premier élément de rétroaction électromécanique (20) présente la première impédance de rétroaction (Z₂₀) avec le premier minimum d'impédance de rétroaction à la première fréquence de minimum d'impédance de rétroaction (f₂₀) entre 40 % de la fréquence de minimum d'impédance de charge (f₁₀) et 100 % de la fréquence de minimum d'impédance de charge (f₁₀) .

5. Dispositif de charge commandé selon l'une quelconque des revendications précédentes, dans lequel la première fréquence de minimum d'impédance de rétroaction (f₂₀) du premier élément de rétroaction électromécanique (20) est fixée au moyen d'un facteur de qualité et/ou d'une fréquence de résonance du premier élément de rétroaction électromécanique (20).

6. Dispositif de charge commandé selon l'une quelconque des revendications précédentes, dans lequel le dispositif de charge commandé comprend un premier ressort de rappel, un premier contact de rappel et/ou un premier assemblage vissé comme premier élément de rétroaction électromécanique (20).

7. Dispositif de charge commandé selon l'une quelconque des revendications précédentes, dans lequel le dispositif de charge commandé comprend en plus du premier élément de rétroaction électromécanique (20) encore un deuxième élément de rétroaction électromécanique (22) qui est réalisé pour conduire ou ramener à l'électronique de commande (12) les signaux parasites haute fréquence provenant de la charge (10).

8. Dispositif de charge commandé selon la revendication 7, dans lequel un circuit parallèle composé de la charge (10) reliée à l'électronique de commande (12) par ledit au moins un conducteur (14) et du deuxième élément de rétroaction électromécanique (22), présente un maximum d'impédance de circuit parallèle à une fréquence de maximum d'impédance de circuit parallèle.

9. Dispositif de charge commandé selon la revendication 7 ou 8, dans lequel le deuxième élément de rétroaction électromécanique (22) présente une deuxième impédance de rétroaction (Z₂₂) avec un deuxième minimum d'impédance de rétroaction à une deuxième fréquence de minimum d'impédance de rétroaction inférieure à la fréquence de minimum d'impédance de charge (f₁₀), et la deuxième fréquence de minimum d'impédance de rétroaction étant inférieure à 50 % de la fréquence de minimum d'impédance de charge (f₁₀).

10. Dispositif de charge commandé selon l'une quelconque des revendications 7 à 9, dans lequel le dispositif de charge commandé comprend un deuxième ressort de rappel, un deuxième contact de rappel et/ou un deuxième assemblage vissé comme deuxième élément de rétroaction électromécanique (22).

11. Dispositif de charge commandé selon l'une quelconque des revendications précédentes, dans lequel la charge (10) est un moteur (10), une soupape, un dispositif d'émission de lumière et/ou un appareil électronique.

12. Dispositif de charge commandé selon l'une quelconque des revendications précédentes, dans lequel la charge (10) peut être ou est installée dans et/ou sur un véhicule.

13. Dispositif de charge commandé selon la revendication 12, dans lequel la charge (10) est un moteur électrique de servofrein, un moteur de pompe ou une soupape de système de freinage.

14. Procédé de fabrication pour un dispositif de charge commandé, comprenant les étapes consistant à :
relier une charge (10) du dispositif de charge commandé par au moins un conducteur (14) à une électronique de commande (12) du dispositif de charge commandé (S1) de telle sorte que la charge (10) peut être commutée et/ou alimentée au moyen d'au moins un signal électrique retransmis par ledit au moins un conducteur (14), la charge (10) reliée à l'électronique de commande (12) par ledit au moins un conducteur (14) présentant une impédance de charge (Z₁₀) avec un minimum d'impédance de charge à une fréquence de minimum d'impédance de charge (f₁₀) ; et
réaliser au moins un premier élément de rétroaction électromécanique (20) pour conduire ou ramener à l'électronique de commande (12) (S2) des signaux parasites haute fréquence provenant de la charge (10) ;
**caractérisé par** l'étape consistant à :
fixer une première impédance de rétroaction (Z₂₀) du premier élément de rétroaction électromécanique (20) avec un premier minimum d'impédance de rétroaction à une première fréquence de minimum d'impédance de rétroaction (f₂₀) entre 1 % de la fréquence de minimum d'impédance de charge (f₁₀) et 100 % de la fréquence de minimum d'impédance de charge (f₁₀).

15. Procédé de fabrication selon la revendication 14, dans lequel la première fréquence de minimum d'impédance de rétroaction (f₂₀) du premier élément de rétroaction électromécanique (20) est fixée au moyen d'un facteur de qualité et/ou d'une fréquence de résonance du premier élément de rétroaction électromécanique (20).
